(19)

Europäisches
Patentamt

European
Patent Office

Office européen
des brevets

(11)  **EP 1 432 132 B1**

(12)  **EUROPEAN PATENT SPECIFICATION**

(45) Date of publication and mention
of the grant of the patent:
**24.09.2008  Bulletin 2008/39**

(51) Int Cl.:
*H04B 1/04* *(2006.01)*        *H03F 1/32* *(2006.01)*

(21) Application number: **03104101.5**

(22) Date of filing: **06.11.2003**

(54) **Wireless communication unit and transmitter circuit therefor**

Drahtlose Kommunikationseinheit und zugehörige Senderschaltung

Unité de communication sans fils et circuit transmetteur y relatif

(84) Designated Contracting States:
**AT BE BG CH CY CZ DE DK EE ES FI FR GR HU
IE IT LI LU MC NL PT RO SE SI SK TR**

(30) Priority: **20.12.2002  GB 0229798**

(43) Date of publication of application:
**23.06.2004  Bulletin 2004/26**

(73) Proprietor: **MOTOROLA INC.
Schaumburg, IL 60196 (US)**

(72) Inventors:
• **Aronas, Alik
67899 Tel Aviv (IL)**

• **Blay, Genadi
67899 Tel Aviv (IL)**
• **Kodner, Leonid
67899 Tel Aviv (IL)**

(74) Representative: **McCormack, Derek James et al
Optimus,
Grove House,
Lutyens Close,
Chineham Court
Basingstoke, Hampshire RG24 8AG (GB)**

(56) References cited:
**EP-A- 1 255 353        US-A- 4 985 686
US-A- 5 101 211        US-A- 5 745 857
US-A1- 2002 084 845    US-B1- 6 349 216**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

### Field of the Invention

This invention relates to a radio transmitter in a wireless communication unit. The invention is applicable to, but not limited to, a radio transmitter configuration to increase linearity of radio transmitter, particularly a radio transmitter that employs a linearisation technique.

### Background of the Invention

Wireless communication systems, for example cellular telephony or private mobile radio communication systems, typically provide for radio telecommunication links to be arranged between a plurality of base transceiver stations (BTSs) and a plurality of subscriber units, often termed mobile stations (MSs). The term mobile station generally includes both hand-portable and vehicular mounted radio units. Radio frequency (RF) transmitters are located in both BTSs and MSs in order to facilitate wireless communication between the communication units.

In the field of this invention, it is known that continuing pressure on the limited radio spectrum available for radio communication systems is focusing attention on the development of spectrally efficient linear modulation schemes. By using spectrally efficient linear modulation schemes, more communication units are able to share the allocated spectrum within a defined coverage area (communication cell). An example of a digital mobile radio system that uses a linear modulation method, such as n/4 digital quaternary phase shift keying (DQPSK), is the TErrestrial Trunked RAdio (TETRA) system, developed by the European Telecommunications Standards Institute (ETSI).

Since the envelopes of these linear modulation schemes fluctuate, intermodulation products can be generated in the non-linear power amplifier. Specifically in the digital mobile radio (PMR) environment, restrictions on out-of-band emissions are severe (to the order of -60dBc to -70dBc in adjacent channels). Hence, linear modulation schemes used in this scenario require highly linear transmitters.

The actual level of linearity needed to meet particular out-of-band emission limits is a function of many parameters, of which the most critical parameters are modulation type and bit rate. Quantum processes within a typical RF amplifying device are non-linear by nature. Only when a small portion of the consumed direct current (DC) power is transformed into radio frequency (RF) power, can the transfer function of the amplifying device be approximated by a straight line, i.e. as in an ideal linear amplifier case. This mode of operation provides a low efficiency of DC to RF power conversion, which is unacceptable for portable units.

The emphasis in portable PMR equipment is to increase battery life. Hence, it is imperative to maximise the operating efficiencies of the amplifiers used. To achieve both linearity and efficiency, so called linearisation techniques are used to improve the linearity of the more efficient amplifier classes of amplifier, for example class AB, B or C amplifiers. One such linearisation technique, often used in designing linear transmitters, is Cartesian Feedback. This is a "closed loop" negative feedback technique, which 'sums' the baseband feedback signal in its digital "I" and "Q" formats with the corresponding generated "I" and "Q" input signals in the forward path. This 'closed loop' I-Q combination is performed prior to amplifying and up-converting this signal to it's required output frequency and power level. The linearising of the power amplifier output requires the accurate setting of the phase and amplitude of a feedback signal.

Details of the operation of such a lineariser is described in the paper "Transmitter Linearisation using Cartesian Feedback for Linear TDMA Modulation" by M Johansson and T Mattsson 1991 IEEE.

In summary, the operation of a Cartesian feedback loop can be defined as follows. Let us define:

x = input signal;
y = output signal;
ε = error signal in Cartesian loop;
A = forward gain of Cartesian loop; and
β = backward gain of feedback loop.

Assume that the non-linearity appears in the amplifier, and then the amplifier's input-to-output transfer function is given by:

$$y = a_1\varepsilon + a_2\varepsilon^2 + a_3\varepsilon^3 \qquad\qquad [1]$$

Assume that the output $y$ can be expressed as a power series in $x$ as such:

$$y = b_1 x + b_2 x^2 + b_3 x^3 \qquad [2]$$

The error signal is:

$$\varepsilon = x - \beta y \qquad [3]$$

Then:

$$y = b_1 x + b_2 x^2 + b_3 x^3 = a_1(x - \beta y) + a_2(x - \beta y)^2 + a_3(x - \beta y)^3 \qquad [4]$$

Substituting equation [2] into the right side of equation [4], expanding and neglecting terms of order higher than three results in:

$$b_1 = \frac{a_1}{1 + a_1 \beta} \qquad [5]$$

$$b_2 = \frac{a_2}{(1 + a_1 \beta)^3} \qquad [6]$$

$$b_3 = \frac{a_3}{(1 + a_1 \beta)^4} \qquad [7]$$

So that:

$$y = \frac{a_1}{(1 + a_1 \beta)} x + \frac{a_2}{(1 + a_1 \beta)^3} x^2 + \frac{a_3}{(1 + a_1 \beta)^4} x^3 \qquad [8]$$

Note that the gain has been reduced by by $\dfrac{1}{1 + a_1 \beta}$

If the input is then increased by this factor, i.e. set $x = \hat{x}(1 - \alpha_1 \beta)$, the output $y$ becomes:

$$y = a_1 \hat{x} + \frac{a_2}{(1 + a_1 \beta)} \hat{x}^2 + \frac{a_3}{(1 + a_1 \beta)} \hat{x}^3 \qquad [9]$$

Thus, it is seen that the feedback reduces the non-linear products of the amplifier by the familiar feedback factor $\dfrac{1}{1 + a_1 \beta}$.

If $\alpha_1 \beta \gg 1$, then the reduction of the non-linear products approximately equals the loop gain factor $\beta A$, where A - is an open-loop Gain.

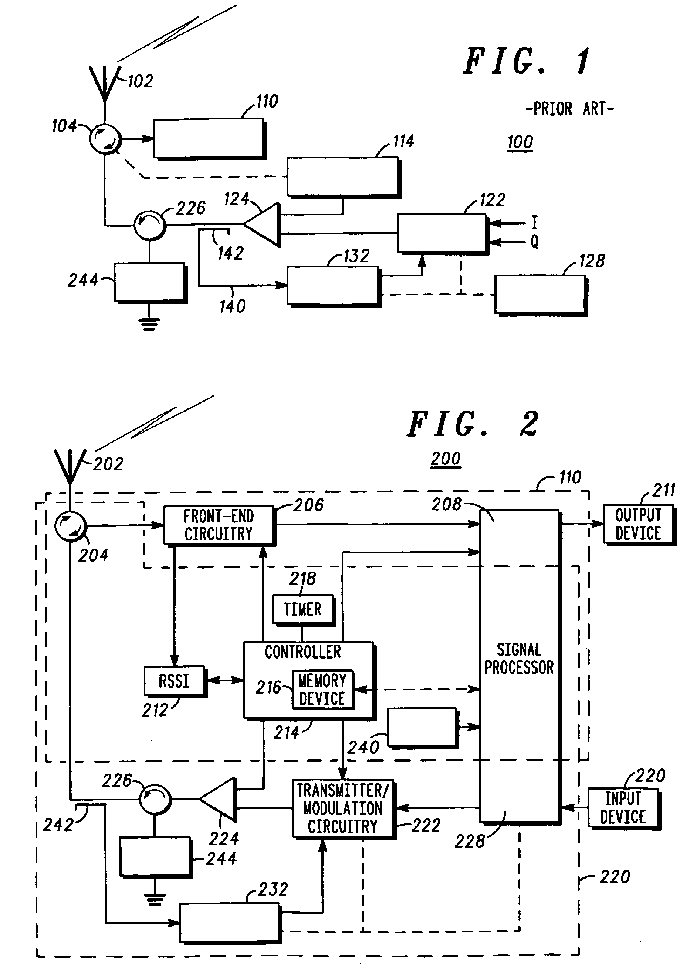

In FIG. 1, a known simplified radio communication unit 100 is shown. The simplified radio communication unit 100 includes a Cartesian Feedback transmitter circuit having a lineariser 122, an up-converter and power amplifier 124, a feedback path 140, and a down-converter 132. The feedback path 140 is arranged by sampling the power amplifier output signal, for example, by use of a directional coupler 142. Connected to the output of the power amplifier 124 is a circulator or isolator 126, which, in turn, is connected to an antenna switch 104.

The antenna switch 104 is connected to an antenna 102 and a receiver chain 110. Controller 114 controls the operation of the antenna switch 104. In this manner, the antenna switch routes radio frequency signals to the antenna from the transmitter when in a transmitting mode, and from the antenna to the receiver chain 110 when in a receiver mode. A microprocessor 128 controls the lineariser 122 and down-converter 132 to set the phase shift and attenuation to be applied to the feedback loop.

The lineariser circuit optimises the performance of the transmitter according to any desired specification, for example to comply with linearity or output power specifications of the communication system, or to optimise the operating efficiency of the transmitter power amplifier. Operational parameters of the transmitter are adjusted to optimise the transmitter performance and include as an example, one or more of the following: amplifier bias voltage level, input power level, phase shift of the signal around the feedback loop. Such adjustments are performed by say, the microprocessor 128.

Digitally modulated 'I' and 'Q' signals are input to the lineariser and eventually output as a RF signal by the power amplifier 124. A real-time Cartesian feedback loop, via the feedback path 140 and the down-converter 132, ensures a linearised output signal is fed to the antenna 102.

Due to the sensitivity of such transmitter circuits, a range of control and adjustment circuits and/or components are needed so that a linear and stable output signal can be achieved under all operating circumstances. For example, the isolator (or circulator) 126 is an essential element to prevent any high power reflections from the antenna 102, say due to any antenna mismatch, from returning to the output port of the power amplifier 124. Such reflections are known to cause damage the power amplifier.

Antenna mismatches may be caused by any number of events, for example, when the antenna is placed near an object such as a human head, the radiation pattern is affected. This causes the antenna input impedance to change and the antenna to operate less efficiently, radiate less, and exhibit mismatch characteristics.

The standard approach for achieving the necessary isolation is to use a high-cost ferrite non-isotropic element, such as an isolator 126 or circulator. The isolator 126 is therefore a key component to protect the power amplifier 124 and feedback loop 140 from such events.

The isolator 126 is often implemented as a three-port nonlinear device that typically provides up to 10-dB of isolation for the power amplifier 124. The isolator 126 uses a ferrite permanent magnet to ensure that the energy is circulated, i.e. power entering from port-1 (transmitter side) is transferred to port-2 (antenna side), from port-2 to port-3 and port-3 to port-1. Hence, a matched (50-ohm) load 144 coupled to port-3 ensures that reflected power from a de-tuned antenna 102 will be routed to the load 144 and not be returned to the power amplifier 124.

With regard to linearity performance, the isolator 126 has a finite 3rd order intermodulation rejection (IMR3) point, often defined as adjacent channel coupled power ratio (ACCPR) at a 25 kHz offset. This offset is the boundary for an adjacent TETRA channel. Hence, when the isolator receives a high input power signal from the power amplifier (PA) 126, it effectively operates as a TETRA transmitter linearity. Such isolators are very expensive.

Furthermore, such a device for an ultra high frequency (UHF at 400 MHz) communication unit requires a large size isolator with footprint of say 10mm*10mm to 12mm*12mm and typically costs at least US$8. Hence, it is bulky and expensive when the driving factors for such devices are miniaturization and lower cost.

Thus, there currently exists a need to provide an improved transmitter circuit arrangement, wherein the abovementioned disadvantages in using a high-cost and large isolator in transmitter circuits of the kind described may be alleviated.

Various circuits are known in the prior art wherein an isolator device is included in a feedback loop for a specific purpose. References describing such circuits include US-A-5,745,857, US 2002/084845, EP-A-1,255,353 and US-A-4, 985, 686. These references do not disclose or suggest the invention to be described as follows.

**Statement of Invention**

In accordance with the present invention, there is provided a wireless communication unit. The wireless communication unit comprises a linearised transmitter having a forward path including an upconverter and a power amplifier operably coupled to a feedback loop for transmitting a linearised radio signal, and an antenna, operably coupled to the forward path of the linearised transmitter, for radiating the radio signal. The feedback loop is an RF Cartesian feedback loop for use in providing a linearised transmitter. The wireless communication unit further comprises an isolation device, operably coupled to the power amplifier and located within the feedback loop in the forward path after the power amplifier thereby improving a linearity performance of the isolation device. In this manner, by provision of the isolation device within the feedback loop, the isolation device's linearity is improved, thereby allowing inexpensive, substantially non-linear isolators to be used in the linearised transmitter circuit.

Preferably, the wireless communication unit further comprises a directional coupler sampling a portion of a transmit signal and routing the portion to the feedback loop, wherein the isolation device is located between the power amplifier and the directional coupler.

Furthermore, the isolation device is preferably an isolator and the linearised transmitter is a Cartesian feedback linearised transmitter such that the isolator's linearity performance is improved by a loop gain factor βA.

In accordance with a second aspect of the present invention, a radio frequency transmitter integrated circuit is provided, as claimed in Claim 7.

Further aspects of the invention are provided in the dependent claims.

### Brief Description of the Drawings

FIG. 1 shows a block diagram of a known linear transmitter arrangement.

Exemplary embodiments of the present invention will now be described, with reference to the accompanying drawings, in which:

FIG. 2 illustrates a block diagram of a wireless communication unit adapted to support the various inventive concepts of a preferred embodiment of the present invention;

FIG. 3 illustrates a block diagram of a radio frequency device topology used in the preferred embodiment of the present invention; and

FIG. 4 illustrates a vector-based representation of the respective radio frequency signal powers in RF feedback of the wireless communication unit of the preferred embodiment of the present invention.

### Description of Preferred Embodiments

Referring now to FIG. 2, a block diagram of a wireless communication unit 200 adapted to support the inventive concepts of the preferred embodiments of the present invention, is illustrated. For the sake of clarity, the wireless communication unit 200 is shown as divided' into two distinct portions - a receiver portion 110 and a transmit portion 220.

The wireless communication unit 200 contains an antenna port 202 to receive an antenna. The antenna port 202 is preferably coupled to an antenna switch 204 that provides signal control of radio frequency (RF) signals in the wireless communication unit 200, as well as isolation, between the receiver 110 and transmit chain 220.
Clearly, the antenna switch 204 could be replaced with a duplex filter, for frequency duplex communication units as known to those skilled in the art.

For completeness, the receiver 110 of the wireless communication unit 200 will be briefly described. The receiver 110 includes a receiver front-end circuitry 206 (effectively providing reception, filtering and intermediate or base-band frequency conversion). The front-end circuit 206 is serially coupled to a signal processing function (generally realised by at least one digital signal processor (DSP)) 208.

A controller 214 is operably coupled to the front-end circuitry 206 so that the receiver can calculate receive bit-error-rate (BER) or frame-error-rate (FER) or similar link-quality measurement data from recovered information via a received signal strength indication (RSSI) 212 function. The RSSI 212 function is operably coupled to the front-end circuit 206. The memory device 216 stores a wide array of data, such as decoding/encoding functions and the like, as well as amplitude and phase settings to ensure a linear and stable output.

A timer 218 is operably coupled to the controller 214 to control the timing of operations, namely the transmission or reception of time-dependent signals.

As regards the transmit chain 220, this essentially includes a processor 228, lineariser circuitry (including transmitter/ modulation circuitry) 222 and an up-converter/power amplifier 224. The processor 228, lineariser circuitry 222 and the up-converter/power amplifier 224 are operationally responsive to the controller 214, with an output from the power amplifier 224 coupled to the antenna switch 204 via isolator 226.

In accordance with a preferred embodiment of the present invention, an improved transmitter topology has been provided. Advantageously, the isolator 226 is arranged to be within the radio frequency (RF) Cartesian feedback topology. In such a configuration, the influence of isolator non-linearity (ACCPR 25 kHz) on the total TETRA Transmitter ACCPR (25 kHz) is eliminated.

The isolator 226 is located after the power amplifier 224, in the same manner as known topologies, thereby preventing the PA load impedance and other PA output characteristics, from antenna impedance changes. Notably, in accordance with the preferred embodiment of the present invention, the isolator is included as part of the Cartesian feedback loop. In this regard, it is now located prior to the directional coupler 242. Thus, the isolator's non-linearity performance is located within the loop and improved by the loop gain factor:

$$A1 \approx \beta A, \text{ where } A1=A \text{ (Forward gain)} - \text{Isolator loss} \approx$$

$$A, \text{ as } A >> \text{Isolator loss.}$$

Preferably, the directional coupler 242 is placed immediately after the isolator output pin, to minimize leakage of radio frequency signals. The isolator 226 is operably coupled to the feedback circuit via the directional coupler 242. The feedback circuit includes a down-converter 232, which forms together with the lineariser circuitry 222 power amplifier 224 and isolator 226 a real-time Cartesian feedback loop to ensure a linear, stable transmitter output. The directional coupler 242, which has a high directivity characteristic, ensures isolation of the Cartesian loop's RF feedback path. The Directional coupler 242 strongly reduces the power of the parasitic waves and signals that return from the antenna and prevents (isolates) the Cartesian feedback from the consequent amplitude and phase influences. J.

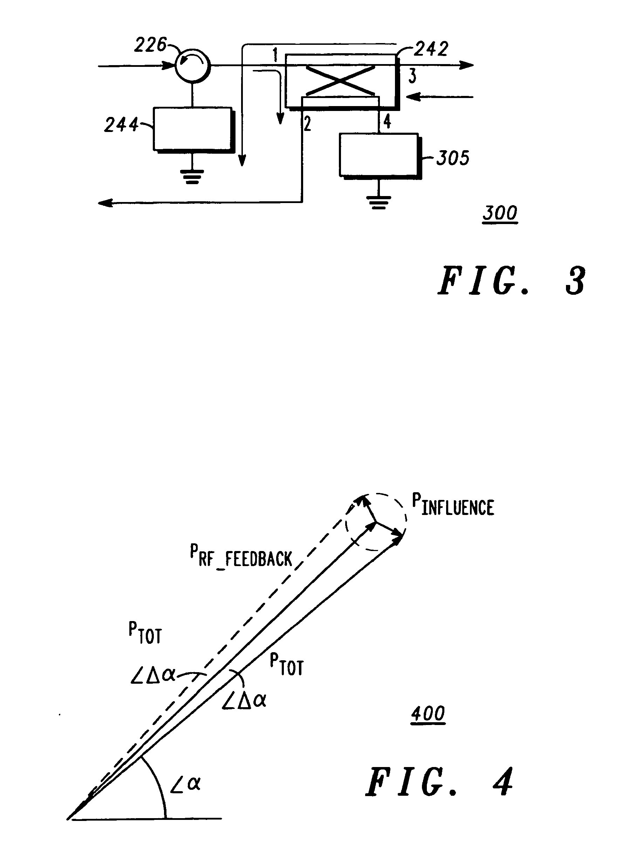

Referring now to FIG. 3, the directional coupler 242 and isolator 226 arrangement is shown in more detail. In effect, the directional coupler is a four-port device with port-1 being used as an input port. Port-1 is operably coupled to port-2 (for reverse power) and port-3 for the primary transmission path. When the power amplifier power is input to port-1, a first (minor) portion of the power amplifier output signal is fed to port-2, to form the feedback signal. A second (major) portion of the power amplifier output signal is fed to port-3 to form the transmitted signal.

The inventors of the present invention have appreciated the benefits that can be gained from using a topology that provides less protection to the feedback loop. The earlier power amplifier linearisation schemes required full isolation to perform properly. Thus, circulators were used. With the recent development of improved linearisation algorithms, the algorithms are able to compensate for most of the antenna impedance variation. Thus, the inventors have appreciated that a reduced isolation performance is required, and that a significant 'linearity' benefit can be gained from locating the isolator inside the feedback loop.

The directional coupler 242 has a parameter called Directivity. The directional coupler's directivity measure defines the ratio between the coupled forward wave and the wave returned from the load 305. Directivity is defined as:

$$\text{Directivity} = \text{Isolation} - \text{Coupling};$$

Where:

$$Isolation = -10 \log \frac{P^{*}_{2}}{P_{3}} [dB],$$

$P_3$ is the input power at port-3 (power, reflected from coupler load), and
$P^{*}_{2}$ is the output power from the isolated port-2.
Furthermore:

$$Coupling = -10 \log \frac{P_{2}}{P_{1}} [dB],$$

Where
$P_1$ is the input power at port-1, and
$P_2$ is the output power from the coupled port.
In accordance with the preferred embodiment of the present invention, the directivity measure illustrates an amount of attenuation of the return wave relative to the useful RF feedback power, i.e. the ratio of the wanted signal that is coupled to the Port-2 to the RF feedback path and the parasitic signal returned from antenna, which penetrate the same RF feedback path. When the directivity ratio is high, the parasitic signal is very small in relation to the wanted signal. Hence, it cannot strongly change the amplitude and phase of the wanted signal in the RF feedback of Cartesian loop. This relationship is graphically illustrated further in FIG. 4.

In the reverse direction, let us consider a disconnected antenna, and thus mismatched antenna port 202. The reflected energy is routed through port-3 of the directional coupler and divided between port-1 (more than 97%) and the load 305 at port-4 (less than 3%). At port-1 the reflected energy is routed to the isolator load 244. Thus, minimal energy is routed back to the power amplifier 224 and approximately 0.03% of the reflected energy is routed back to the feedback loop. Note the figures above relate to a real directional coupler with coupling factor approximately 15 dB and directivity of approximately 20 dB.

Referring now to FIG. 4, a vector-based illustration of the respective powers is shown. The desired RF feedback power $P_2$ (i.e. coupled forward wave on port-2 of the directional coupler 242) is represented by a vector $\vec{P}_{RF\_Feedback}$. RF power reflected from antenna and penetrated at the same port-2 of Directional Coupler $P^*_2$ is represented by vector $\vec{P}_{Reflected}$. The sum is represented by vector $\vec{P}_{TOT}$.

When the directivity of the directional coupler 240 is high, say at least 20 dB, then the reflected power that is fed to port-2 of directional coupler is small (0.03% of reflected signal energy) or ($\vec{P}_{Reflected} << \vec{P}_{RF\_Feedback}$). As a consequence, such a small portion of energy cannot affect the total RF feedback power level and phase. Hence, the RF power (amplitude and phase) of the Cartesian loop feedback is stable ($\vec{P}_{TOT} \approx \vec{P}_{RF\_Feedback}$; $\angle (\alpha-\pm\Delta\alpha) \cong \angle\alpha$)

At the same time, the RF power reflected from the antenna is not affected by the forward RF power at the directional coupler input due to the preferred shortness of the connection between the isolator output pin and the coupler input pin. In this manner, all reflected power is absorbed by the isolator's internal 50Ω load 244.

The performance of the transmitter configuration was tested using a Transmission TDMA mode of operation at full transmit power. The tests showed that RF isolation of the Cartesian loop (forward path and feedback path) was high enough. The ACCPR value, at 25 kHz from the centre frequency, is high and is not dependent on the termination in the directional coupler. Furthermore, the ACCPR value showed an improvement over the ACCPR of the isolator value on its own and equal to ACCPR of the transmitter without an isolator.

It is envisaged that integrated circuit manufacturers may utilise the inventive concepts hereinbefore described. For example, it is envisaged that a radio frequency linearised transmitter integrated circuit (IC) containing the aforementioned transmitter circuit arrangement could be manufactured for incorporating into a wireless communication unit

Advantageously, the inventive concepts of the present invention provide a significant benefit to the manufacturers of linearised transmitter circuits as substantially non-linear isolation devices can be used. It is envisaged that the inventive concepts described herein are not limited to use in subscriber equipment, but may also be utilised in base station equipment.

It will be understood that the wireless communication unit and wireless transmitter circuits, as described above, provide at least the following advantages:

(i) The proposed transmitter circuit provides a significant reduction in the isolator linearity (ACCPR, IMR) requirements. By incorporating the isolator within the Cartesian Loop, the isolator's linearity performance is improved by the loop gain factor βA.

(ii) The transmitter topography achieves the TETRA transmitter ACCPR specification.

(iii) The power amplifier is still protected from any de-tuning of the antenna or mis-matching of the antenna input impedance, thereby also minimising a risk of power amplifier overheating and a risk of self-oscillations in the power amplifier.

(iv) The ability to improve the linearity performance of the isolator allows non-linear devices to be used in the transmitter. This reduces cost and improves manufacturing yield, as the isolator's linearity performance is no longer a problem.

(v) The transmitter output power is also more stable, as the isolator is a part of loop and any insertion loss variation is also controlled and compensate by loop.

Whilst specific, and preferred, implementations of the present invention are described above, it is clear that one skilled in the art could readily apply further variations and modifications of such inventive concepts.

Thus, a wireless communication unit with a linearised transmitter topology has been described that substantially addresses the problems associated with isolator linearity requirements in a linearised transmitter.

**Claims**

1. A wireless communication unit (200) comprising a linearised transmitter (220) having:

a forward path including an upconverter (224) and a power amplifier (224); and
a feedback loop (240) to which the power amplifier is operable coupled for producing a linearised radio signal;

an antenna port (202), operably coupled to the forward path of said linearised transmitter (220), for coupling to an antenna and radiating said radio signal; and

an isolation device (242), operably coupled to the power amplifier (224)and located within the feedback loop;

wherein the feedback loop is an RF Cartesian feedback loop operable to deliver.a baseband feedback signal in I and Q format to the forward path prior to the upconverter and the isolation device is located within the Cartesian feedback loop in the forward path after the power amplifier.

2. The wireless communication unit (200) further including a directional coupler (240) operable to sample a portion of a transmit signal and to route said portion to the Cartesian feedback loop, wherein said isolation device is located between said power amplifier and said directional coupler (240).

3. The wireless communication unit (200) according to Claim 1 or Claim 2 wherein the isolating device is an isolator to isolate a signal reflected back from the antenna port (202) to the power amplifier (224).

4. The wireless communication unit (200) according to claim 3, wherein the linearity performance of the isolator is improved by a loop gain factor βA by inclusion of the isolator in the Cartesian feedback loop.

5. The wireless communication unit (200) according to any preceding Claim, wherein said wireless communication unit is capable of operation according to TETRA standards.

6. The wireless communication unit (200) according to any preceding Claim, wherein said wireless communication unit is a subscriber unit or a base transceiver station.

**Patentansprüche**

1. Einheit zur drahtlosen Kommunikation (200) mit einem linearisierten Sender (220), der folgende Teile enthält:

einen Vorwärtspfad mit einem Aufwärtswandler (224) und einem Leistungsverstärker (224); und

einen Rückkopplungskreis (240), mit dem der Leistungsverstärker funktionsfähig zum Erzeugen eines linearisierten Funksignals verbunden ist;

einen Antennenanschluss (202), der mit dem Vorwärtspfad des linearisierten Senders (220) funktionsfähig verbunden ist, zum Anschluss einer Antenne und zum Ausstrahlen des Funksignals; und

eine Isoliervorrichtung (242), die mit dem Leistungsverstärker (224) funktionsfähig verbunden und innerhalb des Rückkopplungskreises angeordnet ist;

wobei der Rückkopplungskreis ein kartesischer RF-Rückkopplungskreis und derart betreibbar ist, dass er ein Basisbandrückkopplungssignal in I- und Q-Format an den Vorwärtspfad vor dem Aufwärtswandler liefert, und wobei sich die Isoliervorrichtung innerhalb des kartesischen Rückkopplungskreises im Vorwärtspfad hinter dem Leistungsverstärker befindet.

2. Einheit zur drahtlosen Kommunikation (200), die weiterhin einen Richtkoppler (240) enthält, der zum Abtasten eines Teils des übermittelten Signals und zum Weiterleiten dieses Teils an den kartesischen Rückkopplungskreis betreibbar ist, wobei sich die Isoliervorrichtung zwischen dem Leistungsverstärker und dem Richtkoppler (240) befindet.

3. Einheit zur drahtlosen Kommunikation (200) nach Anspruch 1 oder 2, wobei die Isoliervorrichtung ein Isolator ist, der ein vom Antennenanschluss (202) zurück zum Leistungsverstärker (224) reflektiertes Signal isoliert.

4. Einheit zur drahtlosen Kommunikation (200) nach Anspruch 3, wobei die Linearitätsgüte des Isolators durch Einbeziehen des Isolators in den kartesischen Rückkopplungskreis um einen Kreisverstärkungsfaktor βA verbessert wird.

5. Einheit zur drahtlosen Kommunikation (200) nach einem der vorhergehenden Ansprüche, wobei die Einheit zur drahtlosen Kommunikation geeignet ist, gemäß TETRA-Standards zu arbeiten.

6. Einheit zur drahtlosen Kommunikation (200) nach einem der vorhergehenden Ansprüche, wobei die Einheit zur drahtlosen Kommunikation eine Teilnehmereinheit oder eine Transceiver-Basisstation ist.

**EP 1 432 132 B1**

**Revendications**

1. Unité de communication sans fil (200) comprenant un émetteur linéarisé (220), ayant :

   une chaîne d'action comprenant un convertisseur élévateur de fréquence (224) et un amplificateur de puissance (224) ; et
   une boucle de contre-réaction (240) à laquelle un amplificateur de puissance est fonctionnellement couplé pour produire un signal radio linéarisé ;
   un port d'antenne (202), fonctionnellement couplé à la chaîne d'action dudit émetteur linéarisé (220), pour le couplage d'une antenne et le rayonnement dudit signal radio ; et
   un dispositif d'isolation (242), fonctionnellement couplé à l'amplificateur de puissance (224) et situé à l'intérieur de la boucle de contre-réaction ;
   où la boucle de contre-réaction est une boucle de contre-réaction cartésienne RF fonctionnant de façon à délivrer un signal de contre-réaction en bande de base sous un format 1 et Q à la chaîne d'action, avant le convertisseur élévateur de fréquence, et le dispositif d'isolation est situé dans la boucle de contre-réaction cartésienne, dans la chaîne d'action, après l'amplificateur de puissance.

2. Unité de communication sans fil (200) comprenant, en outre, un coupleur directionnel (240) fonctionnant de façon à échantillonner une partie d'un signal de transmission et à acheminer ladite partie vers la boucle de contre-réaction cartésienne, où ledit dispositif d'isolation est situé entre ledit amplificateur de puissance et ledit coupleur directionnel (240).

3. Unité de communication sans fil (200) selon la revendication 1 ou la revendication 2, dans laquelle le dispositif d'isolation est un isolateur servant à isoler un signal réfléchi par le port d'antenne (202) vers l'amplificateur de puissance (224).

4. Unité de communication sans fil (200) selon la revendication 3, dans laquelle les performances de linéarité de l'isolateur sont améliorées d'un facteur de gain de boucle βA, grâce à l'inclusion de l'isolateur dans la boucle de contre-réaction cartésienne.

5. Unité de communication sans fil (200) selon l'une quelconque des revendications précédentes, où l'unité de communication sans fil est capable de fonctionner selon les normes TETRA.

6. Unité de communication sans fil (200) selon l'une quelconque des revendications précédentes, où l'unité de communication sans fil est une unité d'abonné ou une station émettrice-réceptrice de base.

## FIG. 1

-PRIOR ART-

100

## FIG. 2

200

*FIG. 3*

*FIG. 4*

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5745857 A
- US 2002084845 A
- EP 1255353 A
- US 4985686 A

**Non-patent literature cited in the description**

- **M JOHANSSON ; T MATTSSON.** Transmitter Linearisation using Cartesian Feedback for Linear TDMA Modulation. *IEEE,* 1991